Europäisches Patentamt

(19) European Patent Office

Office européen des brevets

(11) Veröffentlichungsnummer: **0 101 543**
**B1**

(12) **EUROPÄISCHE PATENTSCHRIFT**

(45) Veröffentlichungstag der Patentschrift:
04.11.87

(51) Int. Cl.⁴: **G 01 V 9/04,** H 03 K 17/94

(21) Anmeldenummer: **83106357.3**

(22) Anmeldetag: **29.06.83**

(54) **Schaltende Lichtschranke.**

(30) Priorität: **19.08.82 DE 3230903**

(43) Veröffentlichungstag der Anmeldung:
**29.02.84 Patentblatt 84/9**

(45) Bekanntmachung des Hinweises auf die Patenterteilung:
**04.11.87 Patentblatt 87/45**

(84) Benannte Vertragsstaaten:
**BE FR GB IT**

(56) Entgegenhaltungen:
**JP-A-56 047 129**
**US-A-4 012 635**
**US-A-4 295 058**

(73) Patentinhaber: **Erwin Sick GmbH Optik- Elektronik, Sebastian- Kneipp- Strasse 1, D-7808 Waldkirch (DE)**

(72) Erfinder: **Erdmann, Jürgen, Eisenbahnstrasse 35, D-7808 Waldkirch 3 (DE)**
Erfinder: **Kuhn, Fritz, Schwarzwaldstrasse 78, D-7808 Waldkirch 3 (DE)**

(74) Vertreter: **Dipl.- Phys.Dr. Manitz Dipl.- Ing., Dipl.- Wirtsch. Finsterwald Dipl.- Chem.Dr. Heyn Dipl.- Phys. Rotermund Morgan, B.Sc.(Phys.), Robert- Koch- Strasse 1, D-8000 München 22 (DE)**

**Beschreibung**

Die Erfindung betrifft eine schaltende Lichtschranke, bei der auf einer Seite des Überwachungsbereiches ein über den Überwachungsbereich hinweg von einem Lichtsender beaufschlagter Lichtempfänger angeordnet ist, welcher über zwei Betriebsspannungsleitungen, einen Gleichrichter und zwei elektrische Leitungen von einer Wechselspannungsquelle versorgt ist und durch welcher mittels eines Steuersignals in Abhängigkeit davon, ob der Lichtempfänger von Licht des Lichtsenders beaufschlagt ist oder nicht, ein über eine in eine der beiden elektrischen Leitungen eingeschaltete Strommeßvorrichtung an die Wechselspannungsquelle angeschlossener, zwischen den Betriebsspannungsleitungen liegender erster gesteuerter Schalter geschlossen bzw. geöffnet wird oder umgekehrt, und bei der an die mit den Ausgängen des Gleichrichters verbundenen Betriebsspannungsleitungen über einen periodisch geschlossenen zweiten gesteuerten Schalter ein mit den Betriebsspannungsanschlüssen des Lichtempfängers verbundener erster elektrischer Speicher sowie ein von diesem entkoppelter, über einen dritten gesteuerten Schalter entladbarer zweiter elektrischer Speicher angeschlossen ist, wobei der zweite gesteuerte Schalter von der gleichgerichteten, pulsierenden Gleichspannung bei deren Nulldurchgang oder einem Spannungsminimum geschlossen, der dritte gesteuerte Schalter bei Auftreten einer vorgegebenen, einem Bruchteil der pulsierenden Gleichspannung entsprechenden Spannung am speicherseitigen Ausgang des zweiten Schalters zur Entladung des zweiten Speichers geschlossen und der zweite Schalter mit dem Schließen des dritten Schalters wieder geöffnet wird, wobei der dritte Schalter spätestens beim nächsten Nulldurchgang der pulsierenden Gleichspannung wieder geöffnet ist und der erste Schalter nur während der Öffnungsperioden des zweiten bzw. während der Schließperioden des dritten Schalters ein Steuersignal ertält.

Bei einer derartigen schaltenden Lichtschranke werden die beiden elektrischen Speicher, von denen der erste zur Versorgung des Lichtempfängers bei geöffnetem zweiten gesteuerten Schalter dient, stets nur bis zu einem Bruchteil der Gleichspannung aufgeladen, so daß einerseits eine möglichst geringe Belastung des Netzteils gegeben ist und andererseits der Ladestrom für diese Speicher sicher unterhalb dem Grenzwert liegt, bei dem die Strommeßeinrichtung anspricht. Durch die angegebene Steuerung des zweiten und dritten Schalters ist stets gewährleistet, daß der erste Schalter zur Versorgung der Strommeßvorrichtung mit einem hinreichend großen Anzeigestrom stets nur dann durchgeschaltet werden kann, wenn die beiden Speicher aufgrund des geöffneten zweiten gesteuerten Schalters vom Netz getrennt sind. Der zweite gesteuerte Schalter, über den der Ladestrom für die Speicher zugeführt wird, wird nach einer Ansteuerung durch die pulsierende Gleichspannung, im Bereich deren Nulldurchgang er geschlossen wird, dadurch wieder geöffnet, daß bei Erreichen einer vorgegebenen Ladespannung des zweiten Speichers der dritte gesteuerte Schalter geschlossen wird. Mit dem Schließen des dritten gesteuerten Schalters wird somit zur Abkopplung der beiden Speicher vom Netz der zweite gesteuerte Schalter geöffnet.

Bei einer aus der JP-A-56 47 129 bekannten schaltenden Lichtschranke der eingangs genannten Art wird das dem ersten gesteuerten Schalter zugeführte Steuersignal durch eine UND-Verknüpfung des vom Lichtempfänger abgegebenen Ausgangssignals und des am Ausgang des im Entladestromkreis des zweiten Speichers liegenden dritten gesteuerten Schalters vorliegenden Signals gebildet.

Diese UND-Verknüpfung wird dadurch erhalten, daß das Ausgangssignal des Lichtempfängers an die Basis und das Ausgangssignal des dritten gesteuerten Schalters an den Kollektor eines Transistors und an einen zu diesem parallel liegenden Widerstand angelegt ist. Die Steuerelektrode des ersten gesteuerten Schalters ist schließlich über einen Widerstand mit dem Ausgang der den Transistor und den erstgenannten Widerstand umfassenden Parallelschaltung verbunden.

Ein Steuersignal zur Schließung des ersten gesteuerten Schalters wird stets nur dann geliefert, wenn einerseits der dritte gesteuerte Schalter durchgeschaltet und der Transistor aufgrund eines vom Lichtempfänger erfaßten Lichtimpulses gesperrt ist. Wird dagegen der Lichtempfänger nicht von Licht des Lichtsenders beaufschlagt, so bleibt der Transistor durchgeschaltet, so daß sich der zweite elektrische Speicher bei geschlossenem dritten gesteuerten Schalter über die Kollektor-Emitter-Strecke des Transistors entlädt. In diesem Falle führt die beschriebene UND-Verknüpfung nicht zu einem Steuersignal, so daß der erste gesteuerte Schalter geöffnet bleibt.

Der Lichtsender dieser bekannten schaltenden Lichtschranke ist ein frei-schwingender Sender, dessen Sendefrequenz wesentlich höher als die doppelte Frequenz der Versorgungswechselspannung bzw. die Frequenz der pulsierenden Gleichspannung am Ausgang des Gleichrichters ist.

Da der Lichtsender frei, d.h. unabhängig von der jeweiligen Netzfrequenz schwingt, muß seine Sendefrequenz zwangsläufig relativ hoch sein, wenn sichergestellt werden soll, daß der die Strommeßeinrichtung schaltende gesteuerte erste Schalter beim nächsten Nulldurchgang der pulsierenden Gleichspannung rechtzeitig, d.h. möglichst nahe dem Nulldurchgang bei entsprechender Beaufschlagung des Empfängers durch das Licht angesteuert bzw. geschlossen werden soll. Ein in bezug auf den Nulldurchgang der pulsierenden Gleichspannung exakt definierter Schaltzeitpunkt für den ersten gesteuerten Schalter liegt bei dieser bekannten schaltenden Lichtschranke nicht vor. Die sich ergebende Toleranz bezüglich dieses Schaltzeitpunktes ist durch den zeitlichen Abstand der einzelnen Lichtimpulse und somit durch die Sendefrequenz bestimmt. Um diese Toleranzen klein zu halten, muß somit die Sendefrequenz zwangsläufig sehr hoch sein. Eine dichtere Folge von Lichtsendeimpulsen erfordert andererseits wiederum eine höhere Energiezufuhr. Ein solcher höherer Energiebedarf für den Lichtsender ist in der Praxis insbesondere dann von entscheidendem Nachteil, wenn der Lichtempfänger und der Lichtsender von einem gemeinsamen Netzteil versorgt werden sollen. Bei der bekannten Vorrichtung wäre in einem solchen Falle auch der Lichtsender zwangsläufig von dem ersten elektrischen Speicher zu versorgen. Dies würde nun aber zu einer wesentlich höheren Strombelastung des Netzteils führen und insbesondere bei geschlossenem zweiten gesteuerten Schalter, während der Aufladung der beiden elektrischen Speicher, die Gefahr mit sich bringen, daß auch bei noch geöffnetem ersten elektrischen Schalter der durch die Strommeßvorrichtung fließende Strom einen solchen Wert annimmt, daß diese Strommeßvorrichtung bereits anspricht oder die Differenz zwischen dem in der Meßvorrichtung fließenden Ruhestrom und dem Anzeigestrom verringert und somit die Schaltsicherheit bzw. Ansprechsicherheit verringert wird.

Ungünstig bei der bekannten Lichtschranke ist ferner, daß durch die vorgesehene UND-Verknüpfung, die unter anderem den Transistor umfaßt, der Schaltungsaufwand für die Lichtschranke erhöht wird.

Bei einer aus der US-A-4 012 635 bekannten, von einer geglätteten Gleichspannung betriebenen Lichtschranke ist die Strommeßvorrichtung zwischen die Betriebsspannungsleitungen geschaltet und der Lichtsender durch den Entladestrom eines Kondensators zur Abgabe eines Lichtblitzes erregt. Hierbei liegt dieser Kondensator über einen Widerstand stets an der Versorgungsspannung an. Ferner ist auch der Lichtempfänger dieser bekannten Lichtschranke über den Lichtsender stets mit der Versorgungsspannung verbunden. Ferner ist dem Lichtempfänger ein ebenfalls zwischen den Versorgungsspannungsleitungen liegender Sägezahn-Generator nachgeschaltet. Die Sendefrequenz ist höher als die durch den Sägezahn-Generator vorgegebene Schaltfrequenz der Strommeßvorrichtung.

Der Erfindung liegt nun die Aufgabe zugrunde, eine schaltende Lichtschranke der eingangs genannten Art zu schaffen, die bei geringem Schaltungsaufwand und geringer Energieaufnahme weitgehend unabhängig von der jeweiligen Frequenz der Versorgungsspannung einen stets zuverlässigen Betrieb gewährleistet und insbesondere auch sicherstellt, daß bei einer jeweiligen Beaufschlagung des Lichtempfängers durch vom Lichtsender abgegebenem Licht der Schaltzeitpunkt für den ersten gesteuerten Schalter bezüglich des Nulldurchgangs der pulsierenden Gleichspannung stets exakt vorgegeben ist und dieser Schaltzeitpunkt somit stets möglichst nahe dem Nulldurchgang der pulsierenden Gleichspannung bzw. der Versorgungswechselspannung liegt.

Die Aufgabe wird nach der Erfindung dadurch gelöst, daß der vom gleichen Netzteil wie der Lichtempfänger versorgte Lichtsender in den durch den dritten gesteuerten Schalter periodisch geschlossenen Entladestromkreis des zweiten elektrischen Speichers geschaltet ist und die Lichtquelle des Lichtsenders somit vom Entladestrom des zweiten elektrischen Speichers gespeist wird, und daß der erste gesteuerte Schalter unmittelbar durch das vom Lichtempfänger abgegebene Steuersignal beaufschlagt ist.

Aufgrund dieser Ausbildung wird bei einer äußerst geringen Strombelastung des Netzteils auf einfachste Weise eine Synchronisierung des Lichtsenders mit der Netzfrequenz dadurch erhalten, daß der zweite elektrische Speicher vorteilhafterweise sowohl zur Ansteuerung des dritten elektrischen Schalters und somit zum zeitlich genau definierten Öffnen des zweiten elektrischen Schalters als auch zur Versorgung des Lichtsenders, d.h. zur Erzeugung eines Lichtblitzes zu einem bezüglich des Nulldurchgangs der Spannung exakt definierten Zeitpunktes ausgenutzt wird. Das Öffnen des zweiten elektrischen Schalters und damit die Entkopplung der Speicher vom Netz erfolgt stets gleichzeitig mit der Beaufschlagung des Lichtsenders, und zwar unabhängig von der jeweiligen Netzfrequenz stets zu dem Zeitpunkt, bei dem die Ladespannung des zweiten Speichers einen vorgegebenen Spannungswert erreicht hat.

Die Sendefrequenz des Lichtsenders ist stets gleich der doppelten Frequenz der Versorgungswechselspannung bzw. gleich der Frequenz der pulsierenden Gleichspannung. Da somit nach jedem Nulldurchgang der Spannung nur ein Lichtblitz erzeugt wird, kann die Strombelastung des sowohl den Lichtsender als auch den Lichtempfänger speisenden Netzteils gering gehalten werden. Wesentlich ist hierbei auch, daß nicht nur der Lichtempfänger, sondern stets auch der Lichtsender bei geöffnetem zweiten gesteuerten Schalter, wo der erste gesteuerte Schalter in Abhängigkeit von der Beaufschlagung des Lichtempfängers geschlossen werden kann, vom Netz getrennt ist.

Dadurch, daß die Lichtblitze ferner nur bei geöffnetem zweiten Schalter, d.h. unmittelbar nach dem öffnen dieses Schalters auftreten, ist gewährleistet, daß der erste gesteuerte Schalter stets nur bei geöffnetem zweiten Schalter aktiviert werden kann, ohne daß dazu zusätzlicher Schaltungsaufwand zur Bildung einer UND-Verknüpfung, wie dies bei der aus der JP-A-56 47 129 bekannten Anordnung der Fall war, erforderlich ist. Es genügt somit, den ersten gesteuerten Schalter auf die einfachste Weise unmittelbar durch das vom Lichtempfänger abgegebene Steuersignal zu beaufschlagen.

Besonders vorteilhafte Weiterbildungen der Erfindung sind in den abhängigen Ansprüchen angegeben.

Bei der erfindungsgemäßen Lichtschranke ist die Strommeßvorrichtung vorzugsweise eine Relaisspule. Fließt ein Strom durch die Relaisspule, so zieht das Relais an und gibt beispielsweise ein Warnsignal oder ein Stopsignal für eine Maschine ab.

Da die Impulslichtquelle der erfindungsgemäßen schaltenden Lichtschranke netzsynchron arbeitet und der Schaltzeitpunkt des ersten gesteuerten Schalters unmittelbar nach dem Nulldurchgang der Versorgungs-Wechselspannung liegt, kann die schaltende Lichtschranke als Nullspannungsschalter bezeichnet werden. Das Schalten bei der Spannung Null hat den Vorteil, daß nur eine geringe Spannungssteilheit du/dt verarbeitet werden muß. Hieraus ergibt sich, daß nur ein geringer Aufwand zu betreiben ist, um die Schaltung im Hinblick auf Störstrahlungen den postalischen Bestimmungen anzupassen.

Aufgrund der Eigenschaft, daß die Energie zur Ladung der beiden elektrischen Speicher nahe dem Nulldurchgang der Versorgungsspannung entnommen wird und daß sich Lichtsender und Lichtempfänger danach vom Netz automatisch abtrennen, kann eine Schaltung realisiert werden, die nur einen sehr kleinen effektiven Grundstrom über die Strommeßvorrichtung, d.h. die Last, zieht. Dieser effektive Grundstrom kann kleiner als 5 mA gehalten werden. Die Realisierung eines kleinen Grundstromes ist vorzugsweise durch die Verwendung von Thyristoren mit ihren kleinen Zündströmen möglich.

Das vollständige Abtrennen der beiden Speicherkondensatoren von der Netzspannung erlaubt den Betrieb der Schaltung über einen sehr großen Betriebsspannungsbereich, welcher von 20 Volt bis 250 Volt reichen kann.

Die Aufladespannung der beiden elektrischen Speicher, vorzugsweise Kondensatoren, ist über den gesamten Spannungsbereich konstant. Daraus resultiert eine konstante Energie der Lichtblitze sowie eine konstante Systemempfindlichkeit bei allen angelegten Betriebsspannungen.

Der Einsatz eines in Planar-Technologie hergestellten Thyristors erlaubt die Anwendung des GTO-Effektes, da durch die Art der Schaltung das Abschalten des Thyristors bei niedrigen Spannungswerten erfolgt und somit teure Hochspannungs-Transistoren als Schalter entfallen.

Die Erfindung wird im folgenden anhand eines Ausführungsbeispiels unter Bezugnahme auf die Zeichnung näher beschrieben; in dieser zeigt:

Fig. 1 eine schematische Prinzipdarstellung einer schaltenden Lichtschranke,

Fig. 2 eine mit Thyristoren arbeitende schaltende Lichtschranke, und

Fig. 3 verschiedene Diagramme zur Veranschaulichung der Wirkungsweise der schaltenden Lichtschranke gemäß Fig. 2.

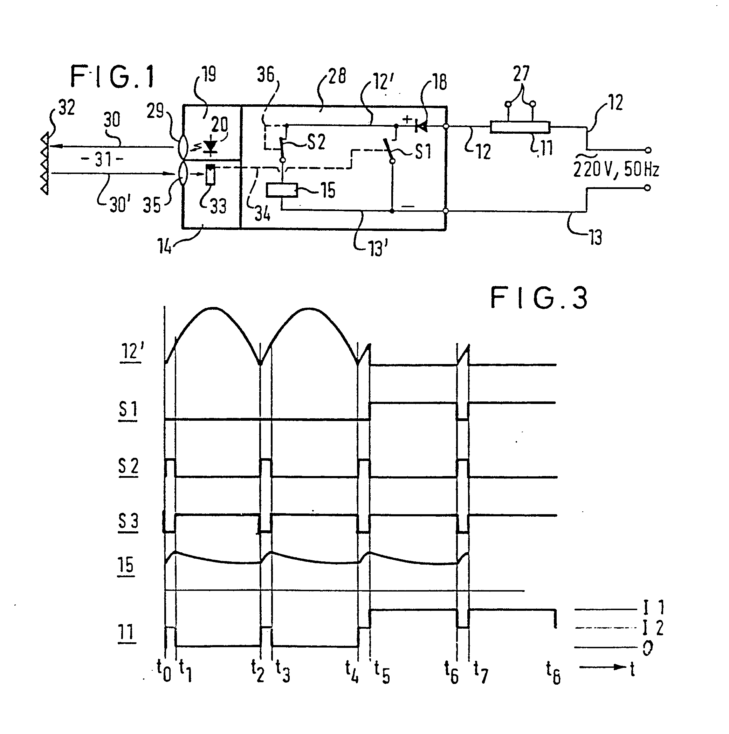

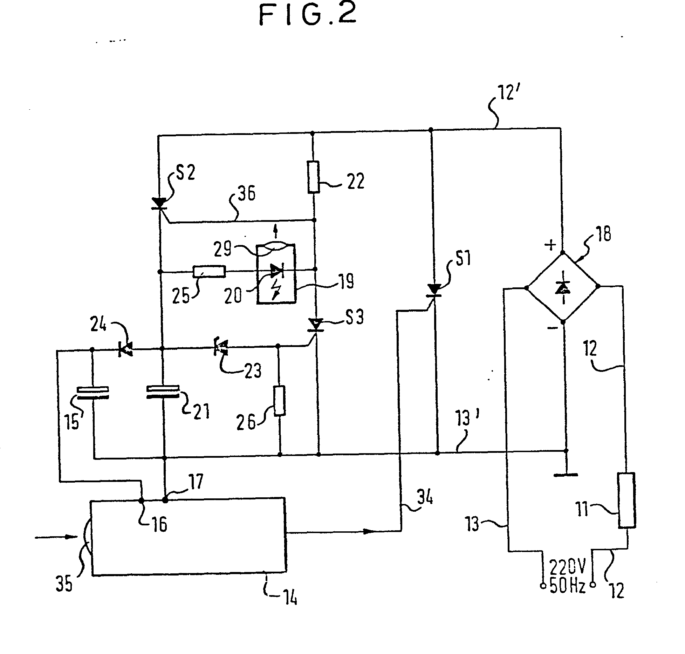

Nach Fig. 1 ist eine schaltende Lichtschranke über zwei elektrische Leitungen 12, 13 an ein 220 V-50 Hz-Netz unmittelbar angeschlossen. In die Leitung 12 ist als Strommeßvorrichtung ein Relais 11 eingeschaltet, welches auf den in der Leitung 12 fließenden Strom anspricht und oberhalb eines vorbestimmten Stromes an einem Ausgang 27 ein Warn- oder Stoppsignal abgibt.

Die Lichtschranke besteht aus einem Lichtempfänger 14, einem Lichtsender 19 und einer mit diesen in einem Gehäuse vereinigten Steuerschaltung 28.

Der Lichtsender 19 umfaßt als Lichtquelle eine impulsmäßig betriebene Leuchtdiode 20, welche über nicht dargestellte optische Elemente wie z. B. Teilerspiegel oder Kondensoren eine Frontlinse 29 beaufschlagt, aus der ein paralleles, nur schematisch angedeutetes Lichtbündel 30 austritt, das einen Überwachungsbereich 31 durchquert, an dessen Ende ein Retroreflektor 32 angeordnet ist, der das Lichtbündel in sich zurückwirft. Das reflektierte Lichtbündel 30' tritt aufgrund der geringfügigen Streuwirkung des Retroreflektors 32 in eine unmittelbar neben der Frontlinse 29 angeordnete Empfangsfrontlinse 35 ein, hinter der ein Photoempfänger 33 angeordnet ist. Zwischen der Frontlinse 35 und dem Photoempfänger 33 können wieder optische Elemente wie Strahlenteiler oder Kondensoren angeordnet sein, um das Licht auf den Photoempfänger 33 zu konzentrieren. Durch eine gestrichelte Linie 34 ist angedeutet, daß der Photoempfänger 33 je nach dem, ob er Licht aus dem Überwachungsbereich 31 empfängt oder nicht, einen ersten gesteuerten Schalter S1 schließt oder öffnet bzw. umgekehrt.

Die eine durch einen Gleichrichter 18 gleichgerichtete wellige Spannung führenden Betriebsspannungsleitungen 12', 13' innerhalb der Steuerschaltung 28 beaufschlagen außerdem über einen zweiten gesteuerten Schalter S2 einen ersten elektrischen Speicher 15. Der Schalter S2 wird in der durch die gestrichelte Linie 36 schematisch angedeuteten Weise von der Betriebsspannung auf der positiven Betriebsspannungsleitung 12' in der Weise beaufschlagt, daß er jeweils beim Nulldurchgang oder unmittelbar nach einem Nulldurchgang der Betriebsspannung schließt und dann kurzzeitig solange geschlossen bleibt, bis der Speicher 15 auf eine gewünschte Spannung aufgeladen ist, Anschließend öffnet dann der gesteuerte -Schalter S2 wieder bis zum Schluß der betreffenden Halbwelle.

Der Schalter S1 ist während der Schließperioden des gesteuerten Schalters S2 in Fig. 1 in nicht dargestellter Weise inaktiv gemacht. In diesem Stadium ist er in der aus Fig. 1 ersichtlichen Weise geöffnet.

Sobald der Schalter S2 geöffnet und der Speicher 15 aufgeladen ist, kann der Lichtempfänger 14 über die an ihn angeschlossenen elektronischen Bauelemente den ersten gesteuerten Schalter S1 je nach dem, ob sich ein Hindernis im Überwachungsbereich 31 befindet oder nicht, schließen oder öffnen.

Die elektronischen Bauelemente, welche die Lichtquelle 20 und den Photoempfänger 33 beaufschlagen, sind in Fig. 1 nicht im einzelnen dargestellt. Sie ergeben sich jedoch aus Fig. 2, in der gleiche Bezugszahlen entsprechende Teile wie in Fig. 1 darstellen. Zur Veranschaulichung der erfindungsgemäßen Schaltung sind in Fig. 2 jedoch der Lichtsender 19 und der Lichtempfänger 14 entgegen den tatsächlichen Verhältnissen, welche sich aus Fig. 1 ergeben, räumlich getrennt dargestellt.

Nach Fig. 2 werden die die pulsierende Gleichspannung führenden Betriebsspannungsleitungen 12', 13' über den in diesem Falle als Zweiweggleichrichter ausgebildeten Gleichrichter 18 an die die Netzspannungszuführenden elektrischen Leitungen 12, 13 angeschlossen, in denen wieder das den Strom überwachende Relais 11 angeordnet ist.

Ein den zweiten gesteuerten Schalter bildender Thyristor S2 verbindet die positive Betriebsspannungsleitung 12' über eine Diode 24 mit einem den ersten elektrischen Speicher bildenden Kondensator 15, dessen anderer Pol an die Minus-Betriebsspannungsleitung 13' angelegt ist. Der mit dem Thyristor S2 verbundene Pol des Speicherkondensators 15 liegt an dem einen Betriebsspannungsanschluß 16 des Lichtempfängers 14 an. Der andere Betriebsspannungsanschluß 17 des Lichtempfängers 14 ist mit der vorzugsweise an Masse liegenden Minus-Betriebsspannungsleitung 13' verbunden.

Die Steuerelektrode des Thyristors S2 ist über eine Steuerleitung 36 und einen Widerstand 22 an die Plus-Betriebsspannungsleitung 12' angeschlossen. Die Steuerleitung 34 zur Steuerelektrode eines den ersten gesteuerten Schalter bildenden Thyristors S1 liegt am Ausgang des Lichtempfängers 14 an.

Die Steuerelektrode eines einen dritten gesteuerten Schalter bildenden Thyristors S3 ist über eine Zenerdiode 23 an die Kathode des Thyristors S2 angelegt.

Weiter ist ein dem ersten Speicherkondensator 15 im wesentlichen parallelgeschalteter als Zweiter elektrischer speicher dienender Kondensator 21 vorgesehen. Die beiden Pluspole der Kondensatoren 15, 21 sind durch die Diode 24 verbunden, welche so gepolt ist, daß der Kondensator 15 über den Thyristor S2 aufgeladen werden kann.

Die Kathode des Thyristors S2 ist außerdem über einen Widerstand 25 mit der im Lichtsender 19 angeordneten Leuchtdiode 20 verbunden deren anderer Pol an der Anode des Thyristors S3 anliegt.

Zwischen der Steuerelektrode des Thyristors S3 und der Minus-Betriebs-Spannungsleitung 13' ist ein Widerstand 26 geschaltet. Die Anode des Thyristors S3 liegt außerdem am Widerstand 22 an.

Der gesteuerte Thyristor S3 wird über die Zenerdiode 23 von dem Thyristor S2 bzw. der über ihn am Speicherkondensator 21 erzeugten Spannung derart gesteuert, daß er schließt, sobald die gewünschte Ladespannung am Speicherkondensator 21 anliegt. Aufgrund dieser Schaltung erfolgt die Aktivierung des ersten Thyristors S1 automatisch dadurch, daß der Lichtempfänger 14 immer nur dann von Lichtblitzen beaufschlagt werden kann, wenn der Thyristor S2 geöffnet ist. Wesentlich ist, daß hinter dem Gleichrichter 18 keine Glättungselemente vorliegen, damit eine pulsierende Gleichspannung erhalten wird.

Die Wirkungsweise der elektrischen Lichtschranke nach Fig. 1, 2 wird im folgenden anhand des Diagramms nach Fig. 3 erläutert:

Die Spannung auf der Plus-Betriebsspannungsleitung 12' ist im ersten Diagramm der Fig. 3 in Abhängigkeit von der Zeit $t$ dargestellt. Die ersten beiden Halbwellen, die zu den Zeiten $t_0$ bzw. $t_2$ beginnen, liegen in der aus Fig. 3 ersichtlichen Form vor, wenn der Überwachungsbereich 31 (Fig. 1) durch einen Gegenstand unterbrochen ist, d.h. wenn kein Licht durch die Frontlinse 35 zum Lichtempfänger 14 gelangt. In diesem Fall wird über die Steuerleitung 34 bewirkt, daß der Thyristor S1 ständig offen bleibt.

Die Schließzeiten der Thyristoren S1, S2 und S3 ergeben sich aus dem 2., 3. und 4. Diagramm der Fig. 3, wobei der Zeitmaßstab in allen Diagrammen der gleiche ist.

Man erkennt, daß nach jedem Nulldurchgang der Thyristor S2 kurzzeitig geschlossen ist, um die Kondensatoren 15, 21 aufzuladen. Er öffnet aufgrund der Steuerung über die Steuerleitung 36 bereits, nachdem die Spannung auf der Betriebsspannungsleitung 12' auf einen der Aufladung der Kondensatoren entsprechenden Bruchteil der maximalen Spannung angestiegen ist. Die Ursache hierfür ist die Schließung des Thyristors S3.

Die Funktion der Schaltung nach Fig. 2 ist wie folgt: Sobald also die Spannung auf der Plus-Betriebsspannungsleitung 12' durch Null geht und wieder anzusteigen beginnt, wird der Thyristor S2 über den Widerstand 22 gezündet. Der gezündete Thyristor S2 lädt nun den Speicherkondensator 21 unmittelbar und den weiteren Speicherkondensator 15 über die Diode 24 auf.

Während dieser Zeit wird der Thyristor S3 über den Widerstand im Sperrzustand gehalten.

Überschreitet nun die Spannung am Speicherkondensator 21 einen bestimmten Wert (Summe der Zenerdiodenspannung und der Spannung am Widerstand 26), so wird die Zenerdiode 23 leitend und zündet den Thyristor S3. Dieser schaltet nun die Steuerelektrode des Thyristors S2 auf das Potential der Minus-Betriebsspannungsleitung 13' (Potential 0). Für den Thyristor S2 bedeutet dies, daß seine Steuerelektrode kurzfristig um die betreffende bestimmte Spannung abzüglich der Flußspannung des Thyristors S3 negativer als seine Kathode wird. Bei dem vorzugsweise verwendeten Planar-Thyristor fließt nun der Anodenstrom über die Steuerelektrode ab, was bei derartigen Thyristoren zum Ausschalten der Anoden-Kathoden-Strecke führt. Dies wird als GTO-Effekt (gate turn off) bezeichnet.

Die Kondensatoren 15 und 21 sind somit jetzt vom Netz getrennt. Für die verbleibende Zeit bis zum nächsten Nulldurchgang der Versorgungsspannung bleibt der Thyristor S3 gezündet und zieht über den Widerstand 22 einen kleinen Haltestrom. Sobald dieser Haltestrom kurz vor dem folgenden Nulldurchgang der Versorgungsspannung unterschritten wird, löscht der Thyristor S3. Der Thyristor S2 kann nun über den Widerstand 22 wieder gezündet werden und der Ladevorgang beginnt von neuem.

Während der oben beschriebenen Zündung des Thyristors S3 wird der Kondensator 21 über den Widerstand 25 und die Leuchtdiode 20 sowie den Thyristor S3 entladen. Die Leuchtdiode 20 gibt einen Lichtblitz ab. Der Widerstand 25 dient hierbei zur Strombegrenzung durch die Leuchtdiode 20.

Da der Kondensator 15 über die Diode 24 geladen wurde, bleibt seine Ladung während des Zündens des Thyristors S3 erhalten. Die Spannung am Kondensator 15 dient der Stromversorgung des Lichtempfängers 14 über die Betriebsspannungs-Anschlüsse 16, 17.

Bei nicht unterbrochenem Überwachungsbereich 31 zündet der Lichtempfänger 14 über die Steuerleitung 34 den Thyristor S1. Der Zündzeitpunkt ist aus dem S1-Diagramm in Fig. 3 ersichtlich.

Ein Abschalten des Thyristors S1 ist nicht nötig, da Thyristoren beim Unterschreiten des Haltestroms von selbst löschen.

Bei der erfindungsgemäßen Lichtschranke ist die Stromaufnahme des Lichtsender-Empfängers sehr gering. Bei geöffnetem Schalter S1 fließt somit nur ein sehr kleiner Strom durch die Strommeßvorrichtung bzw. das Relais 11. Selbst ein als Strommeßvorrichtung verwendetes Kleinrelais kann bei diesem kleinen Strom nicht anziehen. Aufgrund der Speicherung in den Kondensatoren 15, 21 wird die Betriebsspannung für den Lichtempfänger 14 und den Lichtsender 19 auch dann nicht unterbrochen, wenn der Schalter S1 geschlossen und das als Strommeßvorrichtung dienende Relais 11 an Spannung angelegt wird.

Nachdem die Lichtschranke während der beiden ersten Halbwellen gemäß Fig. 3 unterbrochen ist, kann während dieser Zeit der Thyristor S1 nicht schließen, was sich aus dem zweiten Diagramm in Fig. 3 ergibt.

Das fünfte Diagramm zeigt den Ladungszustand des Speicherkondensators 15. Dieser wird immer während der Schließperioden des Schalters S2 bis zu einer vorbestimmten maximalen Spannung aufgeladen. Während der Restzeit der Halbperiode entlädt sich der Speicherkondensator 15 langsam und stetig über den Lichtempfänger 14. Die Kapazität des Speicherkondensators 15 muß so groß sein, daß bis zum Schluß der Halbwelle eine ausreichende Betriebsspannung für den Lichtempfänger 14 zur Verfügung steht.

Es sei nun angenommen, daß nach der zweiten Halbwelle der im Überwachungsbereich 31 (Fig. 1) angeordnete Gegenstand herausgenommen wird, so daß das reflektierte Lichtbündel 30' über die Frontlinse 35 den Photoempfänger 33 erreichen kann.

Gemäß dem dritten Diagramm in Fig. 3 wird zu den Zeitpunkten $t_4$, $t_6$ wieder der Schalter S2 geschlossen und der Kondensator 15 aufgeladen. Die zum Zeitpunkt $t_5$ bzw. $t_7$ erfolgende Schließung des Schalters S3 bewirkt die Auslösung des Lichtblitzes und damit die Beaufschlagung des Lichtempfängers 15 mit Licht, was über die Steuerleitung 34 die Schließung des Schalters S1 zur Folge hat. Dies ist im zweiten Diagramm (S1) wiedergegeben. Auch bei den übrigen Diagrammen ist das - mit einer Unterstreichung versehene - Bezugszeichen desjenigen Schaltungsteils angegeben, dessen zeitlichen Spannungs- bzw. Stromverlauf das Diagramm wiedergibt.

Das sechste Diagramm in Fig. 3 gibt in Abhängigkeit von der Zeit den Strom durch das Relais 11 wieder.

Bei unterbrochener Lichtschranke fließt nur immer während der relativ kurzen Zeitperioden von $t_0$ bis $t_1$ und von $t_2$ bis $t_3$ ein Strom, dem jedoch eine lange Pause folgt. Die Dauer des Stromflusses durch das Relais 11 wird durch die kurzen Schließzeiten des Schalters S2 bestimmt.

Bei nicht unterbrochener Lichtschranke und geschlossenem Schalter S1 schließt jedoch von den Zeitpunkten $t_5$ bzw. $t_7$ ab bis zu den Zeitpunkten $t_6$ bzw. $t_8$ ein wesentlich erhöhter Strom, welcher das Relais 11 zum anziehen bringt. Die Differenz zwischen dem das Relais 11 zum Anziehen bringenden Strom I1 und dem Ruhestrom I2 ist in Fig. 3 nicht maßstabsgetreu dargestellt. In Wirklichkeit ist diese Differenz wesentlich größer als sie im sechsten Diagramm in Fig. 3 angedeutet ist.

**Patentansprüche**

1. Schaltende Lichtschranke, bei der auf einer Seite des Überwachungsbereiches (31) ein über den Überwachungsbereich hinweg von einem Lichtsender (19) beaufschlagter Lichtempfänger (14) angeordnet ist, welcher über zwei Betriebsspannungsleitungen (12', 13') einen Gleichrichter (18) und zwei elektrische Leitungen (12, 13) von einer Wechselspannungsquelle versorgt ist und durch welchen mittels eines Steuersignals in Abhängigkeit davon, ob der Lichtempfänger (14) von Licht des Lichtsenders (19) beaufschlagt ist oder nicht, ein über eine in eine der beiden elektrischen Leitungen (12, 13) eingeschaltete Strommeßvorrichtung (11) an die Wechselspannungsquelle angeschlossener, zwischen den Betriebsspanr.ungsleitungen (12', 13') liegender erster gesteuerter Schalter (S1) geschlossen bzw. geöffnet wird oder umgekehrt, und bei der an die mit den Ausgängen des Gleichrichters (18) verbundenen Betriebsspannungsleitungen (12', 13') über einen periodisch geschlossenen zweiten gesteuerten Schalter (S2) ein mit Betriebsspannungsanschlüssen (16, 17) des Lichtempfängers (14) verbundener erster elektrischer Speicher (15) sowie ein von diesem entkoppelter, über einen dritten gesteuerten Schalter (S3) entladbarer zweiter elektrischer Speicher (21) angeschlossen ist, wobei der zweite gesteuerte Schalter (S2) von der gleichgerichteten, pulsierenden Gleichspannung bei deren Nulldurchgang oder einem Spannungsminimum geschlossen, der dritte gesteuerte Schalter (S3) bei Auftreten einer vorgegebenen, einem Bruchteil der pulsierenden Gleichspannung entsprechenden Spannung am speicherseitigen Ausgang des zweiten Schalters (S2) zur Entladung des zweiten Speichers (21) geschlossen und der zweite Schalter (S2) mit dem Schliessen des dritten Schalters (S3) wieder geöffnet wird, wobei der dritte Schalter (S3) spätestens beim nächsten Nulldurchgang der pulsienender Gleichspannung wieder geöffnet ist und der erste Schalter (S1) nur während der Öffnungsperioden des zweiten bzw. während der Schließperioden des dritten Schalters (S2) bzw. (S3) ein Steuersignal erhält, dadurch gekennzeichnet, daß der vom gleichen Netzteil wie der Lichtempfänger (14) versorgte Lichtsender (19) in den durch den dritten gesteuerten Schalter (S3) periodisch geschlossenen Entladestromkreis des zweiten elektrischen Speichers (21) geschaltet ist und die Lichtquelle (20) des Lichtsenders (19) somit vom Entladestrom des zweiten elektrischen Speichers (21) gespeist wird, und daß der erste gesteuerte Schalter (S1) unmittelbar durch das vom Lichtempfänger (14) abgegebene Steuersignal beaufschlagt ist.

2. Schaltende Lichtschranke nach Anspruch 1, dadurch gekennzeichnet, daß die gesteuerten Schalter Thyristoren (S1, S2, S3) sind.

3. Schaltende Lichtschranke nach Anspruch 1 oder 2, dadurch gekennzeichnet, daß die Steuerelektrode des zweiten Thyristors (S2) vorzugsweise über einen Widerstand (22) an die Betriebsgleichspannung angeschlossen ist.

4. Schaltende Lichtschranke nach einem der vorhergehenden Ansprüche, dadurch gekennzeichnet, daß die Steuerelektrode des dritten Thyristors (S3) über eine Zenerdiode (23) an die aufladende Spannung des zweiten elektrischen Speichers (21) angeschlossen ist.

5. Schaltende Lichtschranke nach einem der vorhergehenden Ansprüche, dadurch gekennzeichnet, daß die beiden vorzugsweise als Kondensatoren ausgebildeten elektrischen Speicher (15, 21) durch eine in Durchlaßrichtung die Aufladung des ersten Speichers (15) ermöglichende Diode (24) entkoppelt sind.

6. Schaltende Lichtschranke nach einem der vorhergehenden Ansprüche, dadurch gekennzeichnet, daß der Lichtsender (19) über einen Widerstand (25) zwischen die Kathode des zweiten gesteuerten Schalters (S2) und die Anode des dritten gesteuerten Schalters (S3) geschaltet ist, wobei der Widerstand (25) im Entladestromkreis des zweiten elektrischen Speichers (21) liegt.

## Claims

1. A switching light barrier wherein a light receiver (14) illuminated across the monitoring region by a light transmitter (19) is arranged on one side of the monitoring region (31), wherein the light receiver is supplied via two operating voltage lines (12', 13'), via a rectifier (18) and via two electrical lines (12, 13) from an AC voltage source; wherein a first controlled switch (S1) lying between the operating voltage lines (12', 13') and connected to the AC voltage source via a current measuring device (11) inserted into one of the two electrical lines (12, 13) is closed or opened, or vice versa, by the light receiver by means of a control signal in dependence on whether the light receiver (14) is illuminated by the light of the light transmitter (19) or not; and wherein a first electrical store (15) connected to the operating voltage terminals (16, 17) of the light receiver (14), and also a second electrical store (21) which is decoupled from the first electrical store (15) and can be discharged via a third controlled switch (S3), are connected via a periodically closed second controlled switch (S2), with the operating voltage lines (12', 13') which are connected with the outputs of the rectifier (18), with the second controlled switch (S2) being closed by the rectified pulsing DC voltage on its zero passage or at a voltage minimum, with the third controlled switch (S3) being closed on the occurrence of a predetermined voltage at the store side output of the second switch (S2) corresponding to a fraction of the pulsating DC voltage in order to discharge the second store (21), with the second switch (S2) being opened again on closing of the third switch (S3), with the third switch (S3) being opened again at the latest at the next zero passage of the pulsating DC voltage; and with the first switch (S1) only receiving a control signal during the opening periods of the second switch (S2), or during the closing periods of the third switch (S3), characterized in that the light transmitter (19) which is supplied from the same power supply as the light receiver (14) is connected into the discharge current circuit of the second electrical store (21) which is periodically closed by the third controlled switch (S3), and the light source (20) of the light transmitter (19) is thus fed by the discharge current of the second electrical store (21); and in that the first controlled switch (S1) is directly energized by the control signal transmitted by the light receiver (14).

2. A switching light barrier in accordance with claim 1, characterized in that the controlled switches are thyristors (S1, S2, S3).

3. A switching light barrier in accordance with claim 1 or claim 2, characterized in that the control electrode of the second thyristor (S2) is preferably connected to the operating DC voltage via a resistor (22).

4. A switching light barrier in accordance with one of the preceding claims, characterized in that the control electrode of the third thyristor (S3) is connected via a zener diode (23) to the charging voltage of the second electrical store (21).

5. A switching light barrier in accordance with one of the preceding claims, characterized in that the two electrical stores (15, 21) which are preferably constructed as capacitors are decoupled by a diode (24) which, in the conducting direction, makes the charging of the first store (15) possible.

6. A switching light barrier in accordance with one of the preceding claims, characterized in that the light transmitter (19) is connected via a resistor (25) between the cathode of the second controlled switch (S2) and the anode of the third controlled switch (S3), with the resistor (25) lying in the discharge current circuit of the second electrical store (21).

**Revendications**

1. Circuit de couplage pour barrière optique, sur lequel est disposé d'un côté du domaine de surveillance (31) um récepteur de lumière (14) atteint au-delà du domaine de surveillance par un émetteur de lumière (19), qui est alimenté par une source de tension alternative par l'intermédiaire de deux conducteurs de tension de service (12', 13'), d'un redresseur (18) et de deux lignes électriques (12, 13), et qui ferme et qui ouvre, ou l'inverse, au moyen d'un signal de commande, selon que le récepteur de lumière (14) est atteint ou non par la lumière de l'émetteur de lumière (19), par l'intermédiaire d'un instrument de mesure de courant (11), branché sur une des deux lignes électriques (12, 13), un premier interrupteur commandé (S1), monté entre les deux conducteurs de tension de service (12', 13'); sur lequel un premier accumulateur électrique (15), raccordé à des connexions de la tension de service (16, 17) du récepteur de lumière (14), ainsi qu'un deuxième accumulateur électrique (21), découplé de celui-ci et déchargeable au moyen d'un troisième interrupteur (53) commandé, sont reliés aux conducteurs de tension de service (12', 13'), eux-mêmes reliés aux sorties du redresseur (18), par l'intermédiaire d'un deuxième interrupteur commandé (S2), fermé périodiquement; sur lequel le deuxième interrupteur commandé (S2) est fermé par la tension continue pulsée redressée lors de son passage par zéro ou par un minimum de tension, alors que le troisième interrupteur commandé (S3) est fermé à l'apparition d'une tension donnée, correspondant à une fraction de la tension continue pulsée, à la sortie côté accumulateur du deuxième interrupteur (S2) aux fins de décharge du deuxième accumulateur (21), que le deuxième interrupteur (S2) s'ouvre à nouveau à la fermeture du troisième interrupteur (S3), lequel s'ouvre au plus tard lors du passage par zéro suivant de la tension continue pulsée, et que le premier interrupteur (S1) ne reçoit un signal de commande que pendant les périodes d'ouverture du deuxième interrupteur (S2) ou pendant les périodes de fermeture du troisième interrupteur (S3), caractérisé en ce que l'émetteur de lumière (19) alimente par la même unité d'alimentation que le récepteur de lumière (14) est branché sur le circuit de décharge du deuxième accumulateur électrique (21) fermé périodiquement par le troisième interrupteur (S3) commandé, en ce que la source lumineuse (20) de l'émetteur de lumière (19) se trouve ainsi alimentée par le courant de décharge du deuxième accumulateur électrique (21) et en ce que le premier interrupteur commandé (S1) est directement atteint par le signal de commande émis par le récepteur de lumière (14).

2. Circuit de couplage pour barrière optique selon la revendication 1, caractérisé en ce que les interrupteurs commandés (S1, S2, S3) sont des thyristors.

3. Circuit de couplage pour barrière optique selon la revendication 1 ou 2, caractérisé en ce que l'électrode de commande du deuxième thyristor (S2) est, de préférence, reliée par une résistance (22) à la tension continue de commande.

4. Circuit de couplage pour barrière optique selon l'une des revendications précédentes, caractérisé en ce que l'électrode de commande du troisième thyristor (S3) est reliée par une diode Zener (23) à la tension de charge du deuxième accumulateur électrique (21).

5. Circuit de couplage pour barrière optique selon l'une des revendications précédentes, caractérisé en ce que les deux accumulateurs électriques (15, 21) constitués, de préférence, par des condensateurs, sont decouplés au moyen d'une diode (24) permettant la charge du premier accumulateur (15) dans le sens de la conduction.

6. Circuit de couplage pour barrière optique selon l'une des revendications précédentes, caractérisé en ce que l'émetteur de lumière (19) est branché au moyen d'une résistance (25) entre la cathode du deuxième interrupteur commandé (S2) et l'anode du troisième interrupteur commandé (S3), la résistance (25) se trouvant sur le circuit de décharge du deuxième accumulateur électrique (21).

0 101 543

FIG.1

FIG.3

1

# FIG.2